# EUROPÄISCHE PATENTSCHRIFT

(11) **EP 1 191 690 B1**
(45) Veröffentlichungstag und Bekanntmachung des Hinweises auf die Patenterteilung: **20.02.2008**
(21) Anmeldenummer: 01120437.7
(22) Anmeldetag: 27.08.2001
(51) Int. Cl.: H03K 3/0231, H03B 5/20

(54) **Schaltungsanordnung**
Circuit configuration
Ensemble circuit

(30) Priorität: 21.09.2000 DE 10046900
(43) Veröffentlichungstag der Anmeldung: 27.03.2002
(73) Patentinhaber: Fujitsu Siemens Computers GmbH, 80807 München (DE)
(72) Erfinder: Busch, Peter, 86179 Augsburg (DE)
(74) Vertreter: Epping - Hermann - Fischer

(56) Entgegenhaltungen:
- EP-A- 1 003 031
- WO-A-82/02298
- GB-A- 2 276 287
- US-A- 4 324 218
- US-A- 5 614 872
- US-A- 5 929 713

## Beschreibung

Die Erfindung betrifft eine Schaltungsanordnung mit einem integrierten Schaltungsbaustein und einem externen ersten Widerstand, über den ein erster Anschluß des integrierten Schaltungsbausteins mit einem ersten Versorgungspotential verbunden ist, wobei innerhalb des integrierten Schaltungsbaustein der erste Anschluß über einen zweiten Widerstand mit einem zweiten Versorgungspotential verbunden oder verbindbar ist, so daß der externe erste Widerstand und der zweite Widerstand einen Spannungsteiler bilden.

Derartige Schaltungsanordnungen werden häufig bei Oszillatorschaltungen verwendet. Der externe erste Widerstand bildet dabei einen Teil eines RC-Gliedes. Die übrigen Elemente des Oszillatorschaltkreises sind gemeinsam mit anderen Funktionseinheiten in dem integrierten Schaltungsbaustein angeordnet. Beispielsweise bildet der Oszillator einen Taktgenerator für die auf dem integrierten Schaltungsbaustein zu betreibenden Funktionseinheiten. Schaltungsbausteine werden in der Regel in großen Stückzahlen hergestellt, wobei insbesondere die Größe der Schaltungsbausteine einen großen Einfluß auf die Herstellungskosten hat. Vor allem ist hier die Anzahl der benötigten Pins zu betrachten. Ein Gehäuse mit 8 Pins ist deutlich billiger als eines mit 14 Pins. Um die Anzahl der Pins niedrig zu halten, verzichtet man oft auf externe Einstellmöglichkeiten und sieht von einer Konfigurierbarkeit der inneren Eigenschaften des Schaltungsbausteins ab. Dies schränkt die Einsatzmöglichkeiten ein.

Aus der US-A-5 614 872 ist eine Schaltungsanordnung mit einem integrierten Schaltungsbaustein bekannt, der Oszillatorkomponenten beinhaltet und an den ein externer Kondensator angeschlossen ist. Beim Einschalten der Schaltungsanordnung steigt die Spannung am Kondensator an, wobei bei Überschreiten eines Schwellwertes ein Reset-Signal erzeugt wird.

Die US-A-4 324 218 offenbart eine Vorrichtung zur Bestimmung eines Luft-Treibstoff-Verhältnisses. Dabei wird ein resistiver externer Sensor und ein damit verbundener Komparator eingesetzt. Je nach Widerstandswert des Sensors liegt am Ausgang des Komparators eine "0" oder eine "1" an, wobei dieses Signal weiterverarbeitet wird.

Aufgabe der Erfindung ist es, eine Schaltungsanordnung anzugeben, bei der eine externe Einstellmöglichkeit vorgesehen ist, ohne daß dadurch die Anzahl der Pins erhöht wird.

Diese Aufgabe wird erfindungsgemäß durch eine Schaltungsanordnung mit den Merkmalen des Anspruchs 1 gelöst.

In dem beschriebenen Fall, wenn an dem ersten Anschluß ein RC-Glied angeschlossen ist, wird die Frequenz des Oszillators sowohl durch den externen ersten Widerstand als auch durch einen externen Kondensator bestimmt. Daher kann der externe Widerstand innerhalb eines gewissen Rahmens frei gewählt und der Kondensator entsprechend angepaßt werden, um so die gewünschte Frequenz zu erhalten. Wird der Widerstand kleiner gewählt, muß also entsprechend der Kondensator größer gewählt werden und umgekehrt. Dadurch hat man einen Freiheitsgrad, den man beispielsweise zur Bereichsumschaltung verwenden kann. Der Grundgedanke der Erfindung besteht nun darin, daß an dem Spannungsteiler aus dem externen ersten Widerstand und dem zweiten Widerstand, der in der Anordnung als Oszillator die Funktion eines Entladewiderstands übernimmt, die Spannung über dem zweiten Widerstand abgegriffen und mit einem Referenzspannungswert verglichen wird. Je nachdem, in welchem Betriebsmodus der integrierte Schaltungsbaustein betrieben werden soll, wird der externe Widerstand so gewählt, daß der abgegriffene Spannungswert kleiner oder größer als der Referenzspannungswert ist. Der Vergleich wird dabei durch den Komparator durchgeführt.

Zur Festlegung des Zeitpunkts des Vergleichs von der über dem zweiten Widerstand abgegriffenen Spannung mit dem Referenzspannungswert wird das Ansteigen der Versorgungsspannung beim Einschalten der Schaltungsanordnung genutzt. Dazu ist ein Schwellwertdetektor vorgesehen, dessen Eingang mit dem ersten Versorgungspotential verbunden ist, und dessen Ausgangspegel bei Erreichen eines festgelegten Schwellwerts umschaltet. Dies wird als Taktsignal für ein Flip-Flop verwendet, dessen Dateneingang mit dem Ausgang des Komparators verbunden ist.

Vorteilhaft ist, daß der Schwellwertdetektor keinen zusätzlichen Aufwand darstellt, da er in der Regel bereits vorhanden ist.

Der verwendete Anschluß des integrierten Schaltungsbausteins ist zum Anschluß des externen RC-Gliedes ohnehin vorhanden, so daß zur Realisierung der Einstellmöglichkeit kein zusätzlicher Pin erforderlich ist. Die Oszillatorfunktion kann dabei uneingeschränkt genutzt werden. Die Informationsübertragung wird in einem Betriebszustand und einem Spannungsbereich vorgenommen, der normalerweise nicht genutzt ist.

Weitere Vorteile und Ausgestaltungen der Erfindung sind in den Unteransprüchen angegeben.

Die Erfindung wird nachfolgend anhand eines Ausführungsbeispieles näher erläutert. Es zeigt:
- Figur 1: eine Schaltungsanordnung nach dem Stand der Technik,
- Figur 2: eine erfindungsgemäße Schaltungsanordnung mit einem Komparator und
- Figur 3: ein Ausführungsbeispiel mit mehreren Komparatoren.

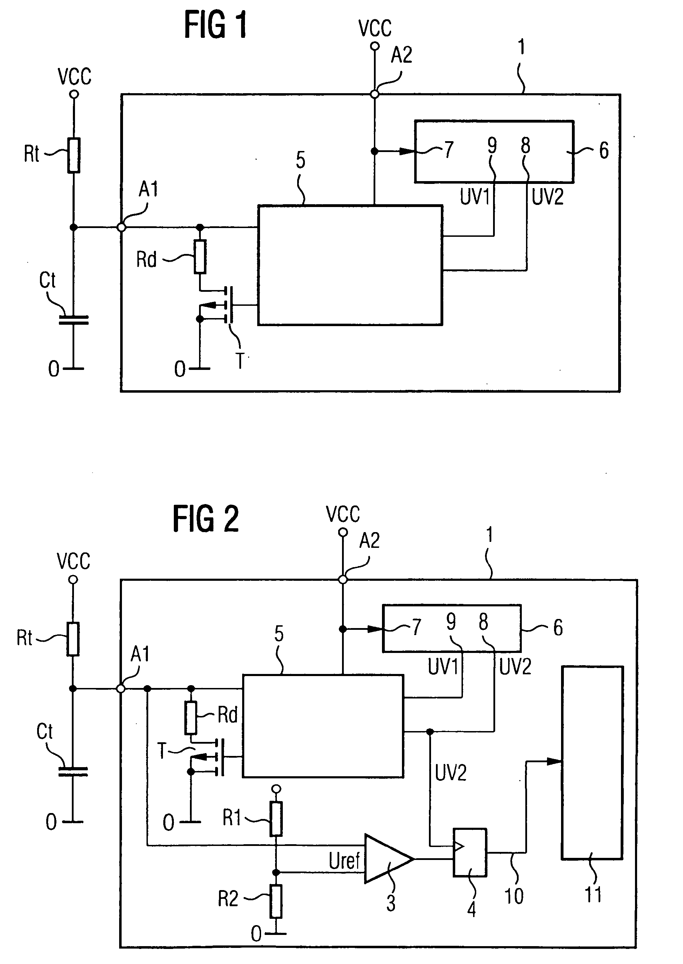

In der in Figur 1 beschriebenen Schaltungsanordnung nach dem Stand der Technik weist der integrierte Schaltungsbaustein neben den Oszillatorkomponenten 5 einen Entladewiderstand Rd auf, der einerseits mit einem ersten Anschluß A1 verbunden ist und andererseits über einen Transistor T mit einem zweiten Versorgungspotential, dem Bezugspotential 0, verbindbar ist. Außerhalb des integrierten Schaltungsbausteins 1 ist der Anschluß A1 über einen ersten Widerstand Rt mit einem Versorgungspotential VCC und über einen Kondensator Ct mit dem Bezugspotential 0 verbunden. Außerdem ist ein Schwellwertdetektor 6 vorgesehen, dessen Eingang 7 mit dem ersten Versorgungspotential VCC, das über einen zweiten Anschluß A2 zugeführt wird, verbunden.

Wird das Versorgungspotential VCC an den integrierten Schaltungsbaustein 1 angelegt, so durchläuft die Spannung zuerst einen Bereich, beispielsweise von 0 V bis 1 V, in dem noch keine internen Ansteuervorgänge möglich sind. Oberhalb dieses Bereichs wird an einem der Ausgänge des Schwellwertdetektors 6 ein Unterspannungserkennungssignal UV1 aktiviert. Dadurch wird der Entladetransistor T durchgeschaltet und über den Entladewiderstand Rd der Eingang belastet. Über den Entladewiderstand Rd wird so der externe Oszillatorkondensator Ct entladen beziehungsweise bleibt entladen.

Steigt das Versorgungspotential VCC danach auf einen Wert an, ab dem auch die übrigen Komponenten ordnungsgemäß arbeiten können, wird der zweite Ausgang 8 des Schwellwertdetektors 6 aktiviert, so daß dort ein Signal UV2 ausgegeben wird, und es beginnt der normale Oszillatorbetrieb. Dabei wird der Transistor T hochohmig, so daß über den Entladewiderstand Rd kein Strom mehr fließt. Im folgenden wird der Oszillatorkondensator Ct über den externen Widerstand Rt bis zu einer festen oberen Schwelle von zum Beispiel 60% der Betriebsspannung aufgeladen. Bei Erreichen des Schwellwertes schaltet der Transistor T durch und entlädt den Kondensator Ct über den Entladewiderstand Rd bis zu einer unteren Schwelle von beispielsweise 30% des ersten Versorgungspotentials VCC. Dann wird der Transistor T hochohmig und der Vorgang beginnt von Neuem.

Gemäß der Erfindung wird der durch den externen Widerstand Rt und den internen Entladewiderstand Rd gebildete Spannungsteiler zur Übermittlung einer Einstellinformation ausgenutzt. Der erste Anschluß A1, der sogenannte Oszillatoranschluß, ist dabei mit einem Komparator verbunden, der die über dem zweiten Widerstand Rd des Spannungsteilers anliegende Spannung mit einem Referenzspannungswert U_{Ref} vergleicht. Im Ausführungsbeispiel von Figur 2 wird der Referenzspannungswert durch einen Spannungsteiler, bestehend aus den Widerständen R1 und R2, bereitgestellt. Der Spannungsteiler ist zum Beispiel auf ein Verhältnis von 1,5% eingestellt. Dem Komparator 3 ist ein flankengetriggertes Flip-Flop 4 nachgeschaltet. Der Ausgang des Komparators 3 ist dabei mit dem Dateneingang des Flip-Flops 4 verbunden. Der Takteingang des Flip-Flop 4 ist mit dem anhand von Figur 1 beschriebenen Signal UV2 verbunden. Dadurch wird zum Zeitpunkt des Erreichens des Schwellwertes, ab dem sämtliche Komponenten ordnungsgemäß arbeiten, der Vergleichswert des Komparators 3 ausgewertet und in dem Flip-Flop 4 gespeichert. Zum Vornehmen der Einstellung auf diese Weise wird also nur ein interner Komparator K und ein Flip-Flop 4 benötigt, wobei dies wesentlich billiger ist als ein zusätzlicher Bauteilanschluß.

Voraussetzung für die beschriebene Funktionalität ist, daß der Entladewiderstand Rd wesentlich kleiner als der externe Widerstand Rt ist, beispielsweise 1,5%. Ebenso muß der Zeitraum, in dem die Versorgungsspannung hochläuft, deutlich größer sein als die Zeitkonstante, die durch Rd und Ct gebildet wird. Dies ist normalerweise der Fall.

Um eine logische "1" am Ausgang des Flip-Flops zu erreichen, muß der externe Widerstand Rt unterhalb eines durch den Aufbau bestimmten Widerstandswerts, beispielsweise 15 kΩ liegen. Ein möglicher Wert wäre in diesem Fall 10 kΩ. Bei einem angenommenen Wert für den Entladewiderstand Rd von 200 Ω wäre dann das Teilerverhältnis beim Start 2%, also größer als die 1,5%, die durch die Widerstände R1 und R2 eingestellt sind.

Um eine logische "0" einzustellen, muß der externe Widerstand Rt oberhalb eines durch den Aufbau bestimmten Widerstandswerts liegen. Er kann zum Beispiel 20 kΩ betragen. Bei einem wiederum angenommenen Wert des Entladewiderstands Rd von 200 Ω ist dann das Teilerverhältnis beim Start 1%, also kleiner als 1,5%. Die übertragene Information ist dann eine logische "0".

Die Betriebsmodusinformation 10 am Ausgang des Flip-Flops 4 wird nun an weitere Funktionseinheiten 11 auf dem integrierten Schaltungsbaustein weitergegeben.

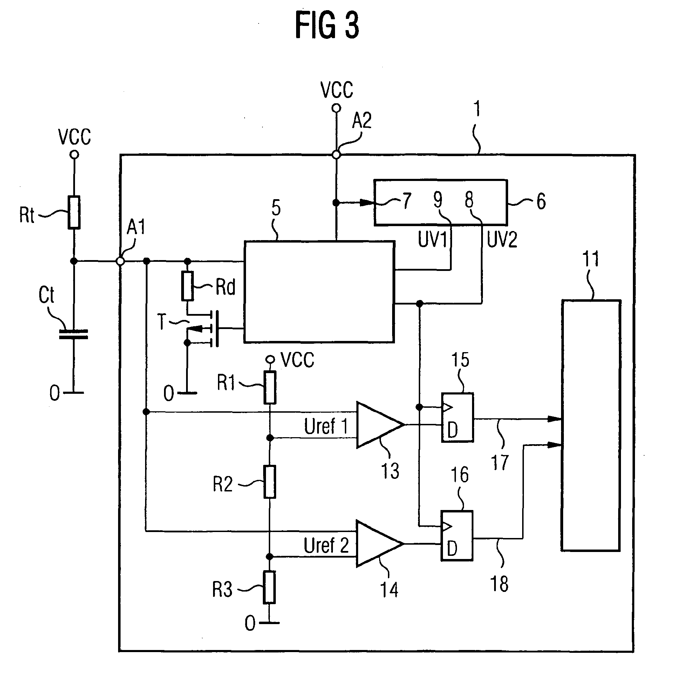

In der Figur 3 ist ein weiteres Ausführungsbeispiel dargestellt, bei dem mehrere Komparatoren 13 und 14 sowie mehrere Flip-Flops 15 und 16 vorgesehen sind. Entsprechend wird der Spannungsteiler aus den Widerständen R1 und R2 durch einen dritten Widerstand R3 erweitert, so daß nun zwei verschiedene Referenzspannungen U_{Ref1} und U_{Ref2} zur Verfügung stehen. Statt einem Betriebsmodussignal in Figur 2 stehen nun zwei Betriebsmodussignale 17 und 18 zur Verfügung. Nach diesem Prinzip läßt sich die erfindungsgemäße Schaltungsanordnung beliebig erweitern. Die Anzahl der einsetzbaren Betriebsmodi ist nur begrenzt durch die Toleranzen der internen Komparatoren und Widerstandswerte und die angestrebte Störsicherheit.

## Patentansprüche

1. Schaltungsanordnung mit
- einem integrierten Schaltungsbaustein (1),
- einem externen Kondensator (Cₜ), der mit einem ersten Anschluß (A1) des integrierten Schaltungsbausteins (1) verbunden ist und der mit Oszillatorkomponenten (5) des integrierten Schaltungsbausteins (1) zusammenwirkt, und
- einem externen ersten Widerstand (Rt), über den der erste Anschluß (A1) des integrierten Schaltungsbausteins (1) mit einem ersten Versorgungspotential (VCC) verbunden ist, wobei innerhalb des integrierten SchaltungsbausteinS(1) der erste Anschluß (A1) über einen zweiten Widerstand (Rd) mit einem zweiten Versorgungspotential (0) verbunden oder verbindbar ist, so daß der externe erste Widerstand (Rt) und der zweite Widerstand (Rd) einen Spannungsteiler bilden, wobei
der integrierte Schaltungsbaustein einen Komparator (3) aufweist, dessen erster Eingang mit dem ersten Anschluß (A1) verbunden ist und an dessen zweitem Eingang ein Referenzspannungswert anliegt (URef; URef1, URef2),
**dadurch gekennzeichnet, daß**
- mit dem Ausgang des Komparators (3) der Dateneingang eines Flipflops (4) verbunden ist und das Flipflop (4) durch einen Schwellwertdetektor (6) getaktet ist, dessen Eingang (7) mit dem ersten Versorgungspotential (VCC) verbunden ist, wobei der Pegel (UV2) eines ersten Ausgangs (8), der mit dem Flipflop (4) verbunden ist, sich bei Erreichen eines ersten Schwellwertes ändert, und
- abhängig von dem Ausgangswert des Komparators (3) bei Taktung des Flipflops (4) ein erster oder ein zweiter Betriebsmodus des Schaltungsbausteins (1) eingestellt wird.

2. Schaltungsanordnung nach Anspruch 1,
**dadurch gekennzeichnet , daß** der Schwellwertdetektor (6) einen zweiten Ausgang (9) aufweist, dessen Pegel (UV1) sich bei Erreichen eines zweiten Schwellwerts ändert, der kleiner als der erste Schwellwert ist, und daß dadurch ein sich zwischen dem zweiten Widerstand (Rd) und dem zweiten Versorgungspotential befindlicher Schalter (T) geschlossen wird.

3. Schaltungsanordnung nach Anspruch 1,
**dadurch gekennzeichnet, daß** mehrere Komparatoren (13, 14) vorgesehen sind, die einen Vergleich des Spannungswertes an dem ersten Anschluß (A1) mit unterschiedlichen Referenzwerten (U_{Ref1}, U_{Ref2}) durchführen, wobei der Ausgangswert jedes Komparators (13, 14) zur Bestimmung des Betriebsmodus des integrierten Schaltungsbaustein (1) herangezogen wird.

## Claims

1. Circuit arrangement having
- an integrated circuit chip (1),
- an external capacitor (Ct) which is connected to a first connection (A1) of the integrated circuit chip (1) and which interacts with oscillator components (5) of the integrated circuit chip (1), and
- an external first resistor (Rt) via which the first connection (A1) of the integrated circuit chip (1) is connected to a first supply potential (VCC), where within the integrated circuit chip (1) the first connection (A1) is connected or can be connected to a second supply potential (0) via a second resistor (Rd), so that the external first resistor (Rt) and the second resistor (Rd) form a voltage divider, the integrated circuit chip having a comparator (3) whose first input is connected to the first connection (A1) and whose second input has a reference voltage value applied to it (URef; URef1, URef2),
**characterized in that**
- the output of the comparator (3) has the data input of a flip-flop (4) connected to it, and the flip-flop (4) is clocked by a threshold value detector (6) whose input (7) is connected to the first supply potential (VCC), the level (UV2) of a first output (8), which is connected to the flip-flop (4), changing when a first threshold value is reached, and
- the output value from the comparator (3) is taken as a basis for setting a first or a second mode of operation of the integrated circuit chip (1) when the flip-flop (4) is clocked.

2. Circuit arrangement according to Claim 1,
**characterized in that** the threshold value detector (6) has a second output (9) whose level (UV1) changes when a second threshold value, which is lower than the first threshold value is reached, and **in that** this closes a switch (T) situated between the second resistor (Rd) and the second supply potential.

3. Circuit arrangement according to Claim 1, **characterized in that** a plurality of comparators (13, 14) are provided which perform a comparison between the voltage value on the first connection (A1) and different reference values (U_{Ref1}, U_{Ref2}), the output value from each comparator (13, 14) being used to determine the mode of operation of the integrated circuit chip (1).

## Revendications

1. Arrangement de circuit comprenant
- un composant circuit intégré (1),
- un condensateur externe (Ct) qui est relié avec une première borne (A1) du composant circuit intégré (1) et qui interagit avec les composants d'oscillateur (5) du composant circuit intégré (1) et
- une première résistance externe (Rt), par le biais de laquelle la première borne (A1) du composant circuit intégré (1) est reliée avec un premier potentiel d'alimentation (VCC), la première borne (A1) étant reliée ou pouvant être reliée à l'intérieur du composant circuit intégré (1) avec un deuxième potentiel d'alimentation (0) par le biais d'une deuxième résistance (Rd) de sorte que la première résistance externe (Rt) et la deuxième résistance (Rd) forment un diviseur de tension, le composant circuit intégré présentant un comparateur (3) dont la première entrée est reliée avec la première borne (A1) et à la deuxième entrée duquel est appliquée une valeur de tension de référence (URef ; URef1, URef2),
**caractérisé en ce que**
- l'entrée données d'une bascule bistable (4) est reliée avec la sortie du comparateur (3) et la bascule bistable (4) est cadencée par un détecteur de valeur de seuil (6) dont l'entrée (7) est reliée avec le premier potentiel d'alimentation (VCC), le niveau (UV2) d'une première sortie (8) qui est reliée avec la bascule bistable (4) changeant lorsqu'une première valeur de seuil est atteinte et
- un premier ou un deuxième mode de fonctionnement du composant circuit (1) est réglé en fonction de la valeur de sortie du comparateur (3) lors du cadencement de la bascule bistable (4).

2. Arrangement de circuit selon la revendication 1, **caractérisé en ce que** le détecteur de valeur de seuil (6) présente une deuxième sortie (9) dont le niveau (UV1) change lorsqu'une deuxième valeur de seuil est atteinte, laquelle est inférieure à la première valeur de seuil, et **en ce qu'**un commutateur (T) qui se trouve entre la deuxième résistance (Rd) et le deuxième potentiel d'alimentation est ainsi fermé.

3. Arrangement de circuit selon la revendication 1, **caractérisé en ce que** plusieurs comparateurs (13, 14) sont prévus, lesquels effectuent une comparaison entre la valeur de tension au niveau de la première borne (A1) et différentes valeurs de référence (URef1, URef2), la valeur de sortie de chaque comparateur (13, 14) étant utilisée pour déterminer le mode de fonctionnement du composant circuit intégré (1).
